(19) Europäisches Patentamt

European Patent Office

Office européen des brevets

(11) **EP 1 202 802 B1**

(12) **EUROPEAN PATENT SPECIFICATION**

(45) Date of publication and mention
of the grant of the patent:
**15.09.2004 Bulletin 2004/38**

(21) Application number: **00967377.3**

(22) Date of filing: **10.08.2000**

(51) Int Cl.7: **B01L 3/00**, B01J 19/00

(86) International application number:
**PCT/US2000/040620**

(87) International publication number:
**WO 2001/012327 (22.02.2001 Gazette 2001/08)**

(54) **MICROFLUIDIC DEVICES FOR THE CONTROLLED MANIPULATION OF SMALL VOLUMES**

MIKROFLUID-VORRICHTUNGEN ZUR GESTEUERTEN HANDHABUNG VON KLEINSTVOLUMEN

DISPOSITIFS A MICROFLUIDES POUR LA MANIPULATION CONTROLEE DE PETITS VOLUMES

(84) Designated Contracting States:
**AT BE CH CY DE DK ES FI FR GB GR IE IT LI LU
MC NL PT SE**

(30) Priority: **12.08.1999 US 148502 P
29.09.1999 US 408060**

(43) Date of publication of application:
**08.05.2002 Bulletin 2002/19**

(73) Proprietor: **UT-Battelle, LLC
Oak Ridge, TN 37831-6255 (US)**

(72) Inventors:
• **RAMSEY, J., Michael
Knoxville, TN 37922 (US)**
• **JACOBSON, Stephen, C.
Knoxville, TN 37919 (US)**

(74) Representative: **Paget, Hugh Charles Edward et al
Mewburn Ellis LLP
York House
23 Kingsway
London WC2B 6HP (GB)**

(56) References cited:
**EP-A- 0 616 218          EP-A- 0 815 940
WO-A-98/00231          US-A- 4 908 112**

Description

FIELD OF THE INVENTION

This invention relates to a microfabricated fluidic device, and in particular, to such a device that is configured for forming and transporting a series of minute volume segments of a material and optionally for storage, retrieval, and analysis thereof and to a method for forming and transporting, and optionally storing and retrieving such a series of minute volume segments.

BACKGROUND OF THE INVENTION

A number of elementary microfabricated fluidic devices have been demonstrated over the past few years. Although many of these fluidic devices are quite simple, they are demonstratively powerful in addressing many realistic applications and may well revolutionize the way that biochemical separations are performed. The majority of the demonstrations have involved transferring known chemical measurement techniques, such as electrophoresis or liquid chromatography, onto microfabricated platforms. Such demonstrations suggest that microfabricated separation devices will be quite useful for improving the time and cost associated with collecting information from such experiments. However, the known devices have not exploited the new experimental approaches that such microfabricated devices potentially enable. We believe that through improvements in microfluidic control, new more powerful biochemical experimental paradigms will arise.

The area of microfabricated fluidics that has received the most attention is electrokinetically driven processes. Electrokinetic fluid manipulations have been demonstrated for mixing and reacting reagents, injection or dispensing of samples, and chemical separations. Electrically driven separation techniques such as capillary electrophoresis (CE), open channel electrochromatography (OCEC) and micellar electrokinetic capillary chromatography (MEKC) have been demonstrated by a number of research groups. Both dsDNA fragments and sequencing products have been sized using microchip capillary gel electrophoresis coupled with laser induced fluorescence detection. Less conventional electrophoretic separations have been studied in post arrays using DC and pulsed electric fields. In addition fluorescence-based competitive immunoassays have been demonstrated using microchip electrophoretic separation of bound and free labeled antigen. These miniature devices have shown performance either equivalent to or better than conventional laboratory devices in all cases investigated and appear to offer the rare combination of "better-faster-cheaper" simultaneously. Microchip separation devices exhibit speed advantages of one to a few orders of magnitude over conventional approaches. The efficiency of electrophoretic separations under diffusion limited conditions is proportional to the voltage drop experienced by the sample. These diffusion limiting conditions can be achieved for short separation distances on microchips due to the narrow axial extent of the injection plugs that are generated. The time of analysis decreases quadratically with separation distance at constant applied potential, which gives a fundamental advantage to microchip- based electrophoretic separations.

Other significant advantages of microchip based chemical separations are the small volumes that can be analyzed, the ability to monolithically integrate sample processing and analysis, and the low cost of replication which makes possible highly parallel analyses. All of these factors are consistent with high throughput analysis and reductions in cost and time to generate biochemical information. Early efforts demonstrating integration of sample processing include post-separation and pre-separation derivatization of amino acids coupled to electrophoretic separations. On-chip DNA restriction digestions and PCR amplifications have been coupled with electrophoretic fragment sizing on integrated monolithic microchips. Cell lysis, multiplex PCR, and CE analysis were performed on plasmic-containing E. coli cells in a single device. Parallel PCR/CE assays of multiple samples in chips containing multiple reaction wells have also been demonstrated. In addition, competitive immunoassay experiments have been performed on a microchip device that included fluidic elements for mixing of sample with reagents, incubation, and electrophoretic separations. Other microfabricated fluidic elements that have been coupled to electrically driven separations include electrospray ionization for analysis by mass spectrometry, and sample concentration using porous membrane elements and solid phase extraction. Devices have also been demonstrated that employ electrokinetic transport solely for performing chemical and biochemical reactions. Examples include devices for enzymatic reaction kinetics, enzyme assays, organic synthesis, and cellular manipulations. All four of these latter applications could eventually be of significant importance to experimental biology, but have not been sufficiently developed at this time.

A number of microfabricated fluidic devices have also been demonstrated that use hydraulic forces for fluid transport. While the use of hydraulic forces can be applied to a broader range of fluidic materials than electrokinetic phenomena, it is less convenient to implement in general. External connections to microchips for hydraulically driven flow are more cumbersome than applying an electric potential. Moreover, electrokinetically driven forces follow the flow of electrical current and thus, allow greater control over transport within a microchannel manifold versus application of pressure or vacuum to a terminus of such a manifold. Electrokinetic forces are also able to generate much higher effective pressures than is practical with hydraulics. The demonstrated capabilities of hydraulically driven devices appear to be trailing that of electrokinetically driven devices. Nonetheless, a number of important capabilities have been reported.

Microfluidic devices for performing PCR have received considerable interest. Early devices included only chambers machined in silicon to act as sample reservoirs while later devices utilized the silicon structure for resistive heating or utilized integrated filters for the isolation of white blood cells. More recently, an interesting device for continuous flow PCR was reported that utilized a single microchannel that meanders through temperature zones to accomplish thermal cycling. Filters for processing cellular materials have been micromachined into silicon substrates. Flow cytometry devices have also been micromachined into silicon and glass substrates and driven hydraulically.

The capability to manipulate reagents and reaction products "on-chip" suggests the eventual ability to perform virtually any type of "wet-chemical" bench procedure on a microfabricated device. The paradigm shift of moving the laboratory to a microchip includes the advantages of reducing reagent volumes, automation or material manipulation with no moving parts, reduced capital costs, greater parallel processing, and higher processing speed. The volume of fluids that are manipulated or dispensed in the microfluidic structures discussed above is on the nanoliter scale or smaller versus tens of microliters at the laboratory scale, corresponding to a reduction of three orders of magnitude or more. Flow rates on the devices that have been studied are of the order of 1mL/yr of continuous operation. By implementing multiple processes in a single device (vertical integration), these small fluid quantities can be manipulated from process to process efficiently and automatically under computer control. An operator would only have to load the sample to be analyzed. Obviously, this serial integration of multiple analysis steps can be combined with parallel expansion of processing capacity by replicating microfabricated structures, e.g., parallel separation channels, on the same device.

Although the so-called "Lab-on-a-Chip" appears to hold many promises, and it is believed that it will fulfill many of them, there are further developments necessary to achieve an impact level that parallels the scale of miniaturization realized in the field of microelectronics. There are at least four significant issues that must be addressed to bring "Lab-on-a-Chip" devices to the next level of sophistication, or processing power, over the next decade. Those issues are: advanced microfluidic control, the "world-to-chip" interface, detection, and viable manufacturing strategies. Presently, electrokinetic manipulation of fluids in microchannel structures represents the state-of-the-art in controlled small volume handling with high precision. The strategy has been to control the time-dependent electric potential at each of the channel terminals to move materials along a desired path. While this strategy has been very effective for valving and mixing in simple designs, it is limited in its applicability and performance as designs become more complex. We believe that new strategies that allow control of electric potentials at multiple points in the microchannel design will be necessary for these more complex structures. Electrokinetic transport also has limitations in the types of solutions and materials that can be manipulated.

The world-to-chip interface is the term we have assigned to the problem of delivering multiple samples or reagents onto microchips to achieve high throughput analysis. Although a given sample can be analyzed in times as brief as a millisecond, multiple samples cannot presently be presented to microchip devices at such a rate. There has been very little effort directed toward this problem, but it represents a major hurdle to achieving ultrahigh throughput experimentation.

WO98/00231 and EP-A-0815940 disclose fluidic devices for forming and transporting series of minute volume segments of material in microchannels.

## SUMMARY OF THE INVENTION

In accordance with a first aspect of the present invention, there is provided a method according to claim 1 of forming and transporting a series of minute volume segments (nanoliter or subnanoliter) of a material e.g. on a fluidic microchip. Reagents, cells, or reaction beads can be injected or inserted into the transport fluid volumes to provide a series of assay or analysis volume. The assay or analysis volumes are transported in series fashion so as to provide serial registration thereof for storage and retrieval for later analysis or other manipulation on the microchip.

In accordance with another aspect of this invention, there is provided an apparatus according to claim 16 for forming and transporting a series of minute volume segments of a material. The device may be a fluidic microchip.

Further embodiments of the device according to this invention include additional channels, sources of reagents, reagent diluents, cells, and/or reaction particles, for inserting such materials into transport volumes formed by sequential pairs of the segmenting fluid volumes. Means for transporting the reagents, cells, and/or reaction beads are also included in such embodiments. In a preferred arrangement, the first microchannel includes one or more loops to provide serial storage of the reaction volumes for later retrieval and analysis or manipulation.

## BRIEF DESCRIPTION OF THE DRAWINGS

The foregoing summary, and the following detailed description, will be better understood when read in conjunction with the attached drawings, in which:

**Figures 1A, 1B, and 1C** are partial schematic diagrams of a microchip showing the sequence of steps in inserting a segmenting fluid volume into a microchannel containing a transport fluid in accordance with one aspect of this invention;

**Figure 2** is a partial schematic diagram of a microchip showing the loading of a reagent into transport volumes between alternating pairs of segmenting fluid volumes in a microchannel in accordance with another aspect of this invention;

**Figure 3** is a partial schematic diagram of a microchip showing the loading of particles between alternating pairs of segmenting fluid volumes in a microchannel in accordance with another aspect of this invention;

**Figure 4** is a partial schematic diagram of a microchip showing the sequence of inserting a segmenting fluid, an enzyme, and a substrate into a microchannel in series fashion in accordance with a further aspect of this invention;

**Figure 5** is a partial schematic diagram of a microchip showing the sequence of inserting a segmenting fluid, a reaction particle, and a reagent fluid into a microchannel in series fashion in accordance with a still further aspect of this invention;

**Figure 6** is a partial schematic diagram of a microchip showing an arrangement for preparing a series of enzyme-bead assays;

**Figure 7** is a schematic diagram of a microchip showing a arrangement for storing and retrieving a series of cells, reaction beads, or reagent volumes; and

**Figure 8** is a schematic of a system for investigating and identifying new drugs which incorporates a microchip as shown in **Figure 7**.

## DETAILED DESCRIPTION

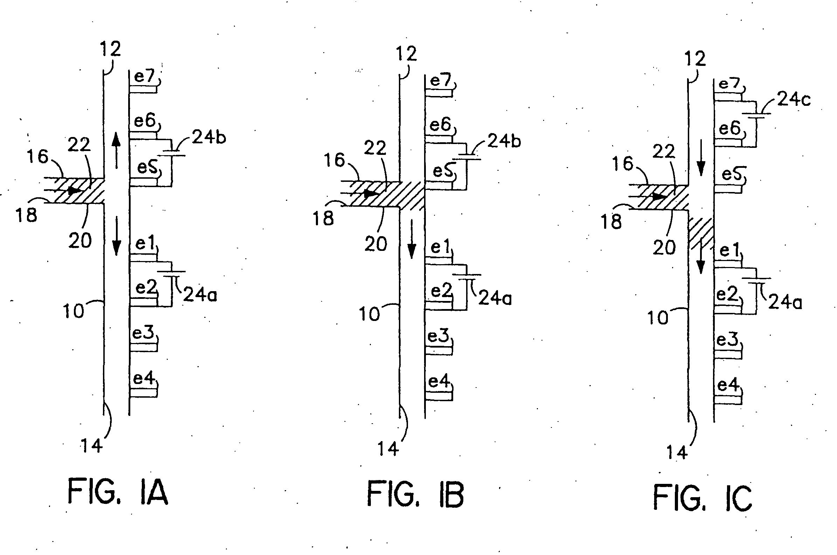

Referring now to the drawings, wherein like reference numerals refer to the same or similar components or features, and in particular to Figs. 1A, 1B, and 1C, there is shown a main microchannel 10. Main microchannel 10 is substantially linear and has an inlet 12 that is connected to a source of transport fluid (not shown) and an outlet 14 that is connected to a waste reservoir (not shown). A branch channel 16 has an inlet 18 and an outlet 20 that intersects with the main microchannel 10 for conducting a segmenting or isolating fluid 22 into the main channel 10. Electrodes e1, e2, e3, and e4 are disposed at spaced apart locations along main microchannel 10 between outlet 20 and outlet 14. Electrodes e5, e6, and e7 are disposed at spaced apart location along the side of main microchannel between outlet 20 an inlet 12. All electrodes are in contact with fluids contained within the microchannels. Either the transport fluid, the segmenting fluid, or both are transportable through the microchannels when exposed to an axial electric field. This function will be referred to as electrokinetic flow and includes such phenomena as electrophoresis, electroosmosis, and electrohydrodynamic transport.

With the arrangement shown in Figs. 1A, 1B, and 1C, the segmenting fluid 22 can be inserted into the main microchannel 10 as a series of discrete, minute volumes. The steps for accomplishing the insertion of the minute volumes of the segmenting fluid 22 are essentially as follows. Main microchannel 10 is filled with the transport fluid. A source of electrical potential 24a is applied between electrodes e1 and e2 and a second source of electrical potential 24b is applied between electrodes e5 and e6. The magnitudes and polarities of the electric potentials are selected to induce electrokinetic flow of the transport fluid in main microchannel 10 in the directions indicated by the arrows in Fig. 1A. Such flow of the transport fluid causes the segmenting fluid 22 to be drawn into main microchannel 10 as shown in Fig. 1B. Assuming that the segmenting fluid has a lower conductivity than the transport fluid, when the segmenting fluid 22 comes into contact with bridging membrane e5, the current between electrodes e5 and e6 drops, and fluid flow in that direction ceases. However, the segmenting fluid 22 continues to flow toward the outlet 14 by virtue of the electrical potential across electrodes e1 and e2. When the desired volume of segmenting fluid has been drawn into main microchannel 10, the volume of segmenting fluid is dispensed into main microchannel 10 by applying a source of electric potential 24c between electrodes e6 and e7. The magnitude and polarity of the electric potential between electrodes e6 and e7 are selected to induce electroosmotic flow of the transport fluid in main microchannel 10 in the directions indicated by the arrows in Fig. 1C. When the volume of segmenting fluid comes into contact with bridging membrane e1, the current between electrodes e1 and e2 drops, and fluid flow in that direction ceases. An electric potential is then applied between electrodes e2 and e3 to continue transporting of the transport fluid and the segmenting fluid volume. Similarly, when the volume of segmenting fluid comes into contact with bridging membrane e2, the current between electrodes e2 and e3 drops, and fluid flow in that direction ceases. An electric potential is then applied between electrodes e3 and e4 to further continue the transporting of the transport fluid, and the segmenting fluid volume, along main microchannel 10. The physical construction and operation of a linear pumping arrangement of the type used in the present invention is described in greater detail in our copending patent application No. 09/244,914 the entire specification of which is incorporated herein by reference.

As an alternative to electrokinetic transport mechanisms, the moving of the transport fluid and the injection of the segmenting fluid, and any other materials used in a device or method according to the present invention can be accomplished by application of pressure or vacuum to the appropriate channel or channels. It is also contemplated that combinations of electrokinetic, pressure, and/or vacuum transport mechanisms can be utilized in implementing a given device or method in accordance with this invention, if desired.

After a segmenting volume has traveled a sufficient distance in main microchannel 10, the process is repeated to insert another segmenting volume. If the pumping rate of the segmenting fluid into the main microchannel 10 is not sufficiently high, then similar electrodes can be placed in branch channel 16.

The segmenting fluid is preferably a liquid that is immiscible in the transport fluid and the reaction fluid(s). Also, the segmenting fluid should be biocompatible with biological reagents that are used. The segmenting fluid is preferably nonconducting for operational control of the reaction/transport process. For example, a nonconducting fluid provides a convenient way to track the location of reaction and pumping volumes in the series of minute volumes transported in the microchannel. Further, the segmenting fluid should have a minimal chemical distribution coefficient for the various reagents that are used. Paraffin and mineral oils are suitable because they have been used to isolate cells in small volumes of extracellular solutions without any deleterious effects. Perfluorocarbons may also be suitable because they are widely used where biocompatibility is required. Silicon oils are yet another suitable class of materials for the segmenting fluid. Gases such as propane may be suitable for use as the segmenting fluid, but could be dissolved into the transport or reaction fluid or escape through a gas-permeable cover plate, thereby reducing their effectiveness for isolating fluid segments.

Following are descriptions of preferred arrangements for implementing various manipulations of minute amounts of materials in serial fashion on a fluidic microchip. Although not shown or described in connection with the various embodiments, the various configurations can include arrangements of electrical contacts as described with reference to Fig. 1 to provide the electric potentials necessary to effectuate the transport of the fluidic materials in the channels of various microfabricated devices. Alternatively, as described above, pressure or vacuum means can also be utilized.

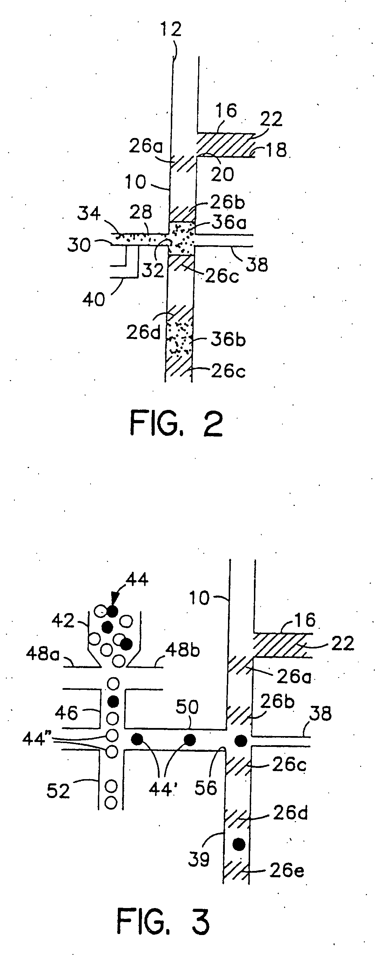

A significant feature of the method according to the present invention, is the capability of inserting a series of minute reaction fluid volumes into the series of minute volume segments in the main microchannel. Referring now to Fig. 2, there is shown an arrangement for the controlled loading of reagents into a series of reaction volumes in main microchannel 10. A plurality of segmenting fluid volumes 26a, 26b, 26d, and 26e are inserted into main microchannel 10 at spaced intervals as described above. A reagent channel 28 has an inlet 30 and an outlet 32 that intersects with the main microchannel 10 for conducting a chemical or biochemical reagent 34 into the main microchannel 10. A waste channel 38 interconnects with main microchannel 10 at a location substantially opposite the outlet 32. A diluent channel 40 interconnects with the reagent channel 28 so that a dilution agent can be mixed into the reaction fluid 34. The steps for accomplishing the insertion of minute volumes of the reaction fluid 34 are essentially as follows.

The transport fluid and the segmenting fluid volumes 26a, 26b, 26c, 26,d, and 26e are pumped through main microchannel 10. When a sequential pair of segmenting fluid volumes 26b and 26c are adjacent the outlet 32, the pumping is stopped and the reaction fluid 34 is pumped into the volume between segmenting fluid volumes 26b and 26c. The transport fluid contained between the segmenting fluid volumes 26b and 26c is preferably conducted into the waste channel 38. Alternatively, the transport fluid can be added to or replaced. The reaction fluid volume 36a is then transported electrokinetically along main microchannel 10. Although the process according to this aspect of the invention has been described with a static mode of operation, it will be recognized that dynamic transfer of the reaction fluid into the reaction volumes will provide higher throughput. Such dynamic operation could be implemented by controlled transport of the transport fluid and the reaction fluid such that the reaction fluid is injected in synchronism with the arrival of a reaction volume at the outlet 32.

Preferably, the reaction fluid volumes 36a and 36b are contained between alternate sequential pairs of segmenting fluid volumes. Thus, as shown in Fig. 2, reaction fluid volume 36a is contained between segmenting fluid volumes 26b and 26c. Whereas, reaction fluid volume 36b is contained between segmenting fluid volumes 26d and 26e. Such alternate sequencing permits the pumping of the reaction fluid volumes through the main microchannel without exposing the reaction fluid to an axial electric field, or in cases where the reaction fluid does not support electrokinetic flow, transport is effected. In other words, the electric potentials are applied only to the segments containing transport fluid. The concentration of the reaction fluid is adjusted by mixing a diluent into the reagent before it is injected into the volume between the segmenting volumes. In this manner, a series of reagent volumes each having a different concentration can be generated.

Another significant feature of the method according to the present invention is the capability to insert a series of reaction particles, such as beads or cells, into the series of minute volume segments in the main microchannel.

Referring now to Fig. 3 there is shown an arrangement for sorting and loading a plurality of reaction particles 44 into a series of reaction volumes in main microchannel 10. A plurality of segmenting fluid volumes 26a, 26b, 26c, 26d, and 26e are drawn into main microchannel 10 at spaced intervals as described above. A particle reservoir 42 contains a plurality of reaction particles 44 in a suspension fluid. A particle sorting channel 46 is connected to the outlet of the reservoir 42 for receiving the particles 44. A pair of focusing channels 48a and 48b interconnect with the particle sorting channel 44. The focusing channels 48a and 48b provide a focusing fluid to narrow down the flow of particles 44 to a single-particle-width stream. Electrokinetic focusing of this type is described in our co-pending patent application No. 09/098,178, and our issued U.S. Patent No. 5,858,187, the entire specifications of which are incorporated herein by reference.

A reaction particle channel 50 intersects the particle sorting channel 46 at a location downstream of the focusing channels 48a and 48b. At the intersection of the reaction particle channel 50 and the particle sorting channel 46, the desired reaction particles 44' are separated from the non-desired particles 44". A potential or pressure is applied to the inlet 50a of channel 50 to direct particles 44' into and along channel 50 to the main microchannel 10. Reaction particle channel 50 has an outlet 56 that interconnects with the main microchannel 10 for conducting the reaction particles into the main microchannel 10. The undesired particles 44" are conducted away along a particle waste channel 52 that extends from the particle sorting channel 46.

The steps for accomplishing the insertion of the reaction particles 44' into the transport stream are essentially as follows. The transport fluid and the segmenting fluid volumes 26a, 26b, 26c, 26d, and 26e are pumped electrokinetically through main microchannel 10. When a sequential pair of segmenting fluid volumes 26b and 26c are adjacent the outlet 56, the particle suspension fluid with a single particle is pumped electrokinetically into the volume between segmenting fluid volumes 26b and 26c, and the transport fluid contained therein is conducted into the waste channel 38. In this arrangement, the waste channel cross section, or at least its inlet, is sized to prevent the particle from passing through. The reaction particle and its volume of suspension fluid is then transported electrokinetically along main microchannel 10 to a detection/analysis channel 39. Preferably, the reaction particles are contained between alternate sequential pairs of segmenting fluid volumes. Thus, as shown in Fig. 3, a first particle is contained between segmenting fluid volumes 26b and 26c. Whereas, a second particle is contained between segmenting fluid volumes 26d and 26e. Such alternate sequencing permits the pumping of the reaction fluid volumes through the main microchannel without exposing the reaction particle to an axial electric field. To that end, the electric potentials are applied only to the segments containing transport fluid.

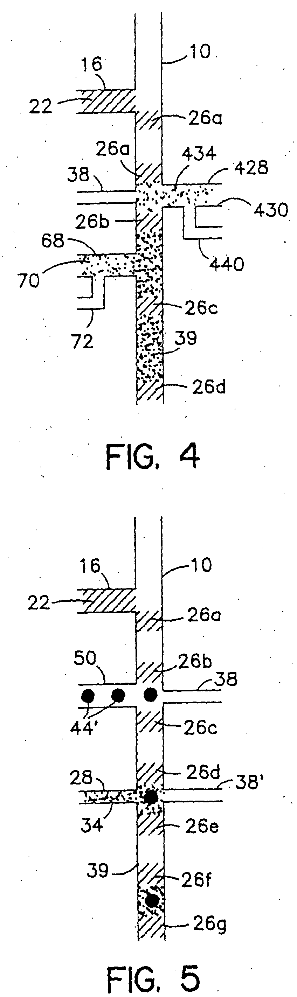

The ability to precisely manipulate fluid flow and reagent mixing with a fluidic microchip lends itself to the study of enzymatic activity and inhibition thereof. An enzyme assay microchip has important implications for drug discovery and medical diagnostics. Referring to Fig. 4, there is shown an arrangement for providing high throughput enzyme assays. A plurality of segmenting fluid volumes 26a, 26b, 26c, and 26d are inserted into main microchannel 10 at spaced intervals as described previously in this specification. An enzyme channel 428 has an inlet 430 and an outlet that intersects with the main microchannel 10 for conducting a fluidic enzyme material 434 into the main microchannel 10. A waste channel 38 interconnects with main microchannel 10 at a location substantially opposite the outlet of enzyme channel 428. A diluent channel 440 interconnects with the enzyme channel 428 so that a dilution agent can be mixed into the enzyme material 434. A substrate channel 68 has an inlet and an outlet that intersects with the main microchannel 10 downstream of the enzyme channel outlet for conducting a fluidic substrate material 70 into the main microchannel 10. A diluent channel 72 interconnects with the substrate channel 68 so that a dilution agent can be mixed into the substrate material 70.

The steps for accomplishing the insertion of minute volumes of the enzyme material 434 into the main microchannel are essentially the same as those described for injecting the reagent fluids with reference to Fig. 2. The transport fluid and the segmenting fluid volumes 26a, 26b, 26c, and 26d are pumped through main microchannel 10. When an enzyme volume segment 434a contained between a sequential pair of segmenting fluid volumes 26b and 26c is adjacent the outlet of substrate channel 68, the pumping is stopped and the fluidic substrate material 70 is pumped into the enzyme volume segment 434a. The enzyme material and the substrate are mixed in the reaction volume. The combined fluid volume is then transported along main microchannel 10 to a detection/analysis channel 39. The concentrations of the enzyme and substrate materials can be varied by varying the amount of diluent mixed into each one, thereby producing a multitude of different enzyme assays which can be transported along the microchannel 10 in serial fashion.

Means for adding an inhibitor to the reaction volume can also be provided. In one embodiment of such a process, a bead shift register is implemented for delivery of the inhibitors. In such an arrangement, the enzyme, substrate, and inhibitor will be reacted, and the location of the bead leading to positive inhibition is recorded for future analysis. An alternative arrangement is to pool a bead library into a reservoir from which the beads are randomly dispensed. Individual beads are transported to a location where a compound is delivered to a reaction volume containing an assay target. The bead is indexed in a shift register arrangement such as that shown and described with reference to Fig. 4, but only for a time sufficient to give an assay result. If the result is negative, the bead is transferred into a general storage reservoir, but if inhibition is observed, the bead is stored in the shift register for either immediate or later identification of the compound, e.g., by electrospray mass spectrometry.

The enzyme activity of the reaction volume is analyzed with appropriate instrumentation in the analysis channel 39 which is located at an appropriate distance downstream from microchannel 10. The actual distance depends on the required incubation time of the enzyme, substrate, and inhibitor, and the average linear velocity of the assay reaction volume.

In one example of an enzyme assay using electrokinetic mixing and transport of reagents on a fluidic microchip in accordance with this embodiment of the present invention, a fluorogenic substrate (resorufin-β-D-galactopyranoside) is mixed with the enzyme β-galactosidase. The kinetics of the reaction are obtained by monitoring the fluorescence of the hydrolysis product, resorufin. Michaelis-Menten constants are derived for the hydrolysis reaction in the presence and absence of inhibitors. A second example of an enzyme assay that can be implemented in the method according to the present invention, is an assay for determining acetylcholinesterase (AchE) activity. This is a two stage assay whereby the AchE hydrolyzes acetylthiocholine to thiocholine which in turn reacts with coumarinylphenylmaleimide (CPM) to produce a highly flourescent thioether, CPM-thiocholine. The fluorescence of the latter product is monitored to determine the enzyme activity. The presence of an inhibitor would reduce the fluorescence signal relative to the absence of such inhibitor.

Shown in Fig. 5 is an arrangement for high throuput screening for cellular assays including cell viability. A plurality of segmenting fluid volumes 26a-26g are inserted into main microchannel 10 at spaced intervals from the branch channel 16 as described above. A cell channel 50 intersects the main microchannel 10 for conducting the cells 44' into the main microchannel 10 at a location downstream of the branch channel 16. The cells are suspended in a biocompatible buffer. A waste channel 38 interconnects with main microchannel 10 at a location substantially opposite the outlet of cell channel 50. The cross section of waste channel 38 is dimensioned to be smaller than the minimum major cross-sectional dimension of the cells 44'. A reagent channel 28 intersects the main microchannel 10 at a location downstream of the cell channel 50. A second waste channel 38' interconnects with main microchannel 10 at a location substantially opposite the outlet of reagent channel 28.

The transport fluid and the segmenting fluid volumes 26a-26g are pumped through main microchannel 10. When a sequential pair of segmenting fluid volumes 26b and 26c are adjacent to the outlet of cell channel 50, the cell suspension fluid is pumped into the reaction volume between segmenting fluid volumes 26b and 26c so that a single cell is inserted into the reaction volume. Alternatively, an ensemble of cells could be loaded into a reaction volume. Concurrently, the transport fluid contained therein is conducted into the waste channel 38. The cell and its volume of suspension fluid in the reaction volume is then transported along main microchannel 10 to the outlet of reagent channel 28. The reagent 34 is pumped into the reaction volume containing the cell, displacing the cell suspension fluid. The cell suspension fluid is conducted away through waste channel 38'. The cell and reagent in the reaction volume are then transported to the detection/analysis channel 39. This process is repeated for each cell. Preferably, the cells 44' are contained in reaction volumes between alternate sequential pairs of segmenting fluid volumes as previously described herein. Cellular assays are examined as a function of time, pumping conditions, and media composition.

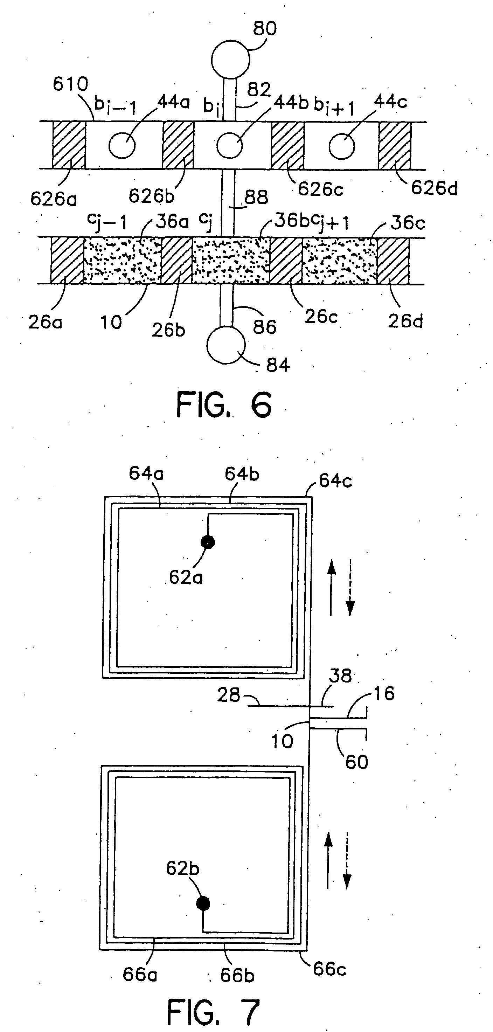

The extremely low consumption of reagent materials in microfluidic chips provides a significant advantage for screening expensive reagent and inhibitor materials and their substrate materials. Peptide libraries for such experiments can be custom synthesized on 10 to 100 micron diameter or larger beads with orthogonal releasable linkers. Shown in Fig. 6 is a basic arrangement for implementing a bead screening procedure on a fluidic microchip in accordance with the present invention. A pair of microchannels 10 and 610 are arranged in spaced parallel relation. A buffer reservoir 80 is connected to the microchannel 610 through a buffer channel 82. A waste reservoir 84 is connected to the microchannel 10 through a waste channel 86. A transfer channel 88 interconnects the microchannel 610 to the microchannel 10 at a location substantially in alignment with the buffer channel 82 and the waste channel 86.

A series of reaction volumes are formed between segmenting fluid volumes 26a-26d in microchannel 10 and a corresponding series of reaction volumes are formed between segmenting fluid volumes 626a-626d in microchannel 610. The reaction volumes in each microchannel are transported along the respective microchannels such that reaction volumes $b_{i-1}$, $b_i$, and $b_{i+1}$ in microchannel 610 are maintained in synchronism with reaction volumes $c_{j-1}$, $c_j$, and $c_{j+1}$ in microchannel 10. Beads 44a, 44b, and 44c are inserted in the reaction volumes $b_{i-1}$, $b_i$, and $b_{i+1}$, respectively, in a manner similar to that described above with reference to Fig. 3. Enzyme volumes 36a, 36b, and 36c are inserted in the reaction volumes $c_{j-1}$, $c_j$, and $c_{j+1}$, respectively, in a manner similar to that described above with reference to Fig. 2.

When each bead arrives at the transfer channel 88, its compound is released from the bead and transferred to the corresponding reaction volume. The bead and its associated reaction volume are then shifted in registration to a downstream station where a fluorogenic substrate is added to the reaction volume ($c_{j-1}$, $c_j$, and $c_{j+1}$) for fluorescence assay. A bead corresponding to a reaction volume that exhibits inhibition can be sorted out and transferred to a station where a second release of compound is effected by an orthogonal cleavage method. That compound can be analyzed by electrospray ionization mass spectrometry to determine its chemical structure.

The utilization of any of the fluidic microchip-implemented procedures described above yields an extended series of discrete assays, cells, beads, etc. transported in a microchannel. The reaction volumes involved are preferably nanoliter or sub-nanoliter volumes, thus providing numerous different compounds, assays, cells, beads, etc. It is also contemplated that larger volumes can be used. Since each reaction volume is discrete, its position can be identified and tracked as it moves through the microchannel, analogous to a series of electronic bits moving through a digital shift register. Shown in Fig. 7 is an arrangement for archiving and retrieving numerous reaction volumes containing reagents, cells, combinational library beads, etc. A microchannel 10 is connected to a source of transport fluid through a transport fluid channel 60. As described previously, a segmenting fluid is provided to the microchannel 10 through a branch channel 16. Reagents, cells, or beads are inserted into the reaction volumes in microchannel 10 through reagent channel 28. A waste channel 38 is interconnected with microchannel 10 for conducting away the transport fluid from the reaction volume.

The microchannel 10 extends in one direction to form a plurality of loops 64a, 64b, and 64c and terminates in a reservoir 62a. Microchannel 10 extends in an opposite direction to form a second plurality of loops 66a, 66b, and 66c, and terminates in a reservoir 62b. In a first mode of operation, the reaction volumes formed between the segmenting fluid volumes are advanced by transporting them in step-wise fashion in the direction shown by the solid arrows and through loops 64a, 64b, and 64c for archiving. In a second mode of operation, the reaction volumes are retrieved by transporting them in step-wise fashion in the direction shown by the dashed arrows. The combined length of loops 66a, 66b, and 66c is similar in length to the combined length of loops 64a, 64b, and 64c, so that the entire series of reaction volumes archived in loops 64a, 64b, and 64c can be retrieved for later analysis.

Although not shown in Fig. 7, the electrode layout needed to implement the archiving/retrieval device for method 1 would be such as to enable the transport of the reaction volumes in two directions. Preferably, the electrodes or contacts would enter from each of the four sides of the loops. The electrodes geometry is selected to provide adequate contact with the microchannel loops at a proper spatial periodicity. With such a layout, materials can be loaded serially into the register to be analyzed immediately or at a later time. The materials can be delivered to reagent or assay stations as the reaction volumes are shifted back and forth between the microchannel loops.

The number of reaction volumes that can be held in the storage bank defined by loops 64a, 64b, and 64c can be estimated using Equation 1 below.

$$ N = \frac{4L_s}{(L_R + L_I)}\left( n - \frac{n(2n-1)}{2}\frac{L_c}{L_s} \right) \qquad \{\text{Eq. 1}\} $$

$L_S$ is the length of one side of the outermost loop, $L_R$ is the length of the reaction volume, $L_I$ is the length of the isolating segment, $L_C$ is the center-to-center spacing between adjacent channels in the loops, and n is the number of loops. For example, if $L_S$ is 100mm, $L_R + L_I$ = 1mm, $L_C$ is 0. 1 mm, and n = 100, then approximately 19010 reaction volumes (N) can be stored in the shift register storage loops. Such a device would use only about 10% of the area of a 100mm×100mm square microchip substrate. Although the preferred arrangement described herein includes one or more loops to form the storage channel, it will be readily appreciated by those skilled in the art that other configurations can be utilized. For example, a serpentine arrangement would be equally effective.

Such shift register storage/retrieval devices are very advantageous for handling combinatorial bead libraries as described with reference to Figs. 5 and 6. Beads from a split-synthesis could be collectively loaded into a reservoir and dispensed, using on-chip bead sorting capabilities, into the storage register. Compounds can be partially photolytically released from the beads as needed or prereleased into the contents of the reaction volume. The bead library can be certified by incorporating an electrospray ionization station on the microchip for mass spectrometric identifination of the reaction compounds. Beads can also be brought to a location where the compound is delivered to a separate reaction volume to perform a biological assay as described with reference to Fig. 6.

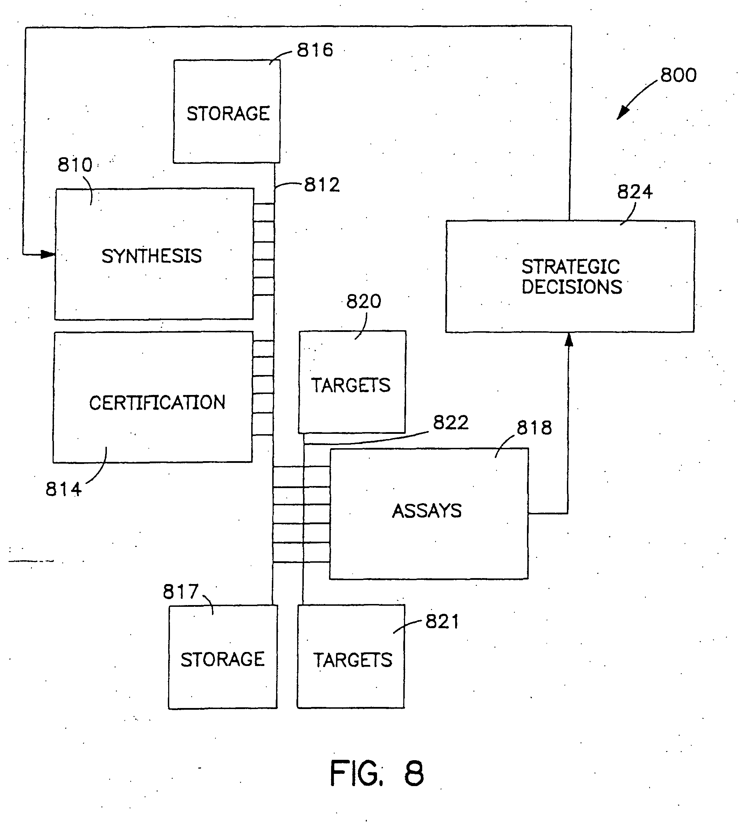

Referring now to Fig. 8, there is shown a system 800 for accomplishing the identification of new drugs. A synthesis module 810 for synthesizing a series of potentially useful drug compounds is connected to a main microchannel 812 through a plurality of insertion channels. Each of the synthesized compounds is inserted into a transport volume and transported along microchannel 812 in the manner described previously hereinabove. A certification module 814 is provided for analyzing and certifying the molecular structure of the synthesized compounds. The certification module is connected to the microchannel 812 through a second plurality of channels for obtaining samples of the synthesized compounds. An assay module 818 for performing screening assays on the series of synthesized compounds against molecular or cellular targets is also provided. Screening module 818 is connected to the microchannel 812 by a third plurality of channels for obtaining samples of the synthesized drug compounds. The target molecules or cells are stored in serial fashion in the target storage modules 820, 821. A second microchannel 822 is disposed between the target storage modules for transporting the targets to the screening module 818.

The series of drug compounds are transported along microchannel 812 to storage modules 816, 817 for later retrieval. This feature permits the drug compounds to be analyzed and/or screened at a time substantially later than the time of synthesis. The results of the screenings performed by the screening module 818 are provided to a decision module 824 which can evaluate the effectiveness of the synthesized compounds and provide feedback to the synthesis module 810 for synthesizing new and different compounds based on the earlier results. In this manner a multitude of new drug compounds can be rapidly and automatically synthesized, certified, and screened on a single microchip.

In view of the foregoing descriptions and the accompanying drawings, it will be appreciated by those skilled in the art that the method and apparatus according to this invention are capable of addressing a broad range of biochemical analysis problems that benefit from precise and automated nanoliter or subnanoliter scale manipulations with high serial throughput capacity. The device and method described herein also lend themselves to multiple parallel expansion which will provide greater throughput for the generation of chemical and biochemical information. The microchannel devices described can manipulate biochemical reaction volumes in a controlled manner to provide rapid results, e.g., rates of at least about 1 to 10 Hz per channel, and rates up to 100 Hz or 1000 Hz are expected to be achievable. The reaction volumes utilized are capable of containing molecular or particulate species without diffusive losses.

The individual reaction volumes are manipulated in serial fashion analogous to a digital shift register. The device includes looped microchannels to provide serial storage of the reaction volumes for later retrieval. The method and apparatus according to this invention have application to such problems as screening molecular or cellular targets using single beads from split-synthesis combinatorial libraries, screening single cells for RNA or protein expression, genetic diagnostic screening at the single cell level, or performing single cell signal transduction studies.

The terms and expressions which have been employed in the foregoing description are used as terms of description and not of limitation. There is no intention in the use of such terms and expressions of excluding any equivalents of the features shown and described or portions thereof. It is recognized, however, that various modifications such as channel dimension, location, and arrangement are possible within the scope of the invention as claimed.

## Claims

**1.** A method of forming and transporting a series of minute volume segments of a material in a microchannel comprising the steps of:

> a. providing a first channel (10) having an inlet end (12) connected to a source of transport fluid and an outlet end (14) connected to a fluid reservoir;
> b. providing a second channel (16) having an inlet end (18) connected to a source of segmenting fluid and an outlet end (20) interconnected with said first channel;
> c. drawing a volume of segmenting fluid (22) into said first channel;
> d. transporting the volume of segmenting fluid in said first channel toward said fluid reservoir; and then
> e. repeating steps c. and d. to form a series of discrete volumes of the segmenting fluid;

> **characterised in that** the step of drawing the volume of the segmenting fluid into the first channel comprises the steps of:

> a. providing first (e1), second (e2), and third (e3) electrical contacts in said first channel at a location between the outlet ends of said first channel and said second channel;
> b. providing fourth (e5), fifth (e6), and sixth (e7) electrical contacts in said first channel at a location between the inlet end of said first channel and the outlet end of said second channel; and
> c. applying a first electrical potential (24a) across said first and second electrical contacts and a second electrical potential (24b) across said fourth and fifth electrical contacts, said first and second electrical potentials having magnitudes and polarities that are effective for inducing flow of said transport fluid in said first channel so as to draw the segmenting fluid into said first channel.

**2.** A method as set forth in Claim 1 comprising the steps of:

> a. reducing the magnitude of the second electrical potential across said fourth and fifth electrical contacts; and
> b. maintaining the magnitude and polarity of the first electrical potential across said first and second electrical contacts until the desired volume of segmenting fluid has been drawn into the first channel.

3. A method as set forth in Claim 2, wherein the step of transporting the volume of segmenting fluid in said first channel comprises the steps of:

    a. applying a third electrical potential (24c) across said fifth and sixth electrical contacts while maintaining the first electrical potential across said first and second electrical contacts until the volume of segmenting fluid reaches said first electrical contact; and then
    b. applying a fourth electrical potential across the second and third electrical contacts, whereby the volume of segmenting fluid is transported toward the second electrical contact.

4. A method as set forth in Claim 1 comprising the step of injecting a volume of a reagent (34, 434) into said first channel between a sequential pair of the volumes of the segmenting fluid.

5. A method as set forth in Claim 4 wherein the step of injecting the reagent comprises the steps of:

    a. providing a third channel (28, 428) having an inlet end (30, 430) connected to a source of reagent and an outlet end (32) interconnected with the first channel;
    b. providing a fourth channel (38) having an inlet end interconnected with the first channel; and
    c. applying an electrical potential between the third channel and the fourth channel to cause the volume of the reagent to flow into said first channel and the transport fluid to flow into said fourth channel.

6. A method as set forth in Claim 4 comprising the step of diluting the concentration of the reagent before it is injected into the first channel.

7. A method as set forth in Claim 4 comprising the step of repeating the injecting of the reagent into the first channel such that a plurality of volumes (36a, 36b) of reagent are injected between non-adjacent, sequential pairs of volumes (26b, 26c; 26d, 26e) of the segmenting fluid.

8. A method as set forth in Claim 7 comprising the step of transporting the plurality of injected volumes of reagent along said first channel toward said fluid reservoir.

9. A method as set forth in Claim 8 comprising the step of sequentially storing the plurality of injected volumes of reagent so that a selected one of said reagent volumes can be retrieved for analysis.

10. A method as set forth in Claim 9 comprising the step of retrieving the selected reagent volume from storage.

11. A method as set forth in Claim 1 comprising the step of inserting a reaction particle (44) into said first channel between a sequential pair of the volumes of the segmenting fluid.

12. A method as set forth in Claim 11 comprising the step of repeating the insertion of the reaction particle into the first channel such that a plurality of reaction particles are inserted between non-adjacent, sequential pairs (26b, 26c; 26d, 26e) of volumes of the segmenting fluid.

13. A method as set forth in Claim 11 comprising the step of transporting the plurality of reaction particles along said first channel toward said fluid reservoir.

14. A method as set forth in Claim 13 comprising the step of sequentially storing the plurality of inserted reaction particles so that a selected one of said reaction particles can be retrieved for analysis.

15. A method as set forth in Claim 14 comprising the step of retrieving the selected reaction particle from storage.

16. An apparatus for forming and transporting a series of minute volume segments of a material comprising:

    a substrate having first (10) and second (16) microchannels formed therein, said first microchannel having an inlet end (12) connected to a source of transport fluid and an outlet end (14) connected to a fluid reservoir, said second microchannel having an inlet end (18) connected to a source of segmenting fluid and an outlet end (20) interconnected with said first microchannel;

    **characterised in that** the apparatus further comprises:

first (e1) second (e2), and third (e3) electrical contacts disposed in said first microchannel at a location intermediate the outlet end of said first microchannel and said second microchannel;

fourth (e5), fifth (e6) and sixth (e7) electrical contacts disposed in said first microchannel at a position intermediate the inlet end of said first microchannel and said second microchannel; and

means for sequentially applying electrical potentials across adjacent pairs of said electrical contacts to (i) draw a volume of the segmenting fluid into said first microchannel, (ii) stop the drawing of the segmenting fluid volume in the first microchannel, and then (iii) transport the volumes of the segmenting fluid in said first microchannel toward said fluid reservoir.

**17.** Apparatus as set forth in Claim 16 comprising:

a third channel (28, 428) having an inlet end (30, 430) connected to a source of reagent and an outlet end (32) interconnected with the first channel;

a fourth channel (38) having an inlet end interconnected with the first channel; and

means for injecting a volume of the reagent between a pair of sequential volumes of the segmenting fluid in said first channel such that the transport fluid disposed between said pair of sequential volumes of the segmenting fluid is caused to flow into said fourth channel.

**18.** Apparatus as set forth in Claim 17 comprising means for applying an electrical potential between the third channel and the fourth channel for injecting the volume of the reagent.

**19.** Apparatus as set forth in Claim 17 comprising means for diluting the reagent when it is injected into the first channel.

**20.** Apparatus as set forth in Claim 18 comprising means for varying the dilution of the reagent to provide a series of volumes of diluted reagent having different concentrations and means for injecting each of the volumes into alternating pairs of the segmenting fluid volumes in said first channel.

**21.** Apparatus as set forth in Claim 17 comprising:

additional electrical contacts located along the first channel between the third channel and the fluid reservoir; and

means for applying electrical potentials between respective pairs of the additional electrical contacts for transporting the reaction volume along said first channel toward said fluid reservoir.

**22.** Apparatus as set forth in Claim 17 wherein said first channel comprises a loop (64a, b, c) for holding a plurality of said diluted reagent volumes disposed between alternating pairs of the segmenting fluid volumes.

**23.** Apparatus as set forth in Claim 16 comprising:

a third channel (50) having an inlet end (50a) connected to a source of reaction particles (44) suspended in a fluid medium and an outlet end interconnected with the first channel;

a fourth channel (38) having an inlet end interconnected with the first channel; and

means for injecting a reaction particle suspended in the fluid medium between a pair of sequential volumes of the segmenting fluid in said first channel such that the transport fluid disposed between said pair of sequential volumes of the segmenting fluid is caused to flow into said fourth channel.

**24.** Apparatus as set forth in Claim 23 comprising means for applying an electrical potential between the third channel and the fourth channel to cause a volume of the fluid medium containing the reaction particle to flow into said first channel and the transport fluid to flow into said fourth channel.

**25.** Apparatus as set forth in Claim 23 comprising means for sorting the reaction particles according to a quality or characteristic of the reaction particles and means for injecting individual reaction particles between a pair of sequential volumes of the segmenting fluid in said first channel.

**26.** Apparatus as set forth in Claim 25 comprising means for controlling the injection of each of the reaction particles such that the reaction particles are inserted between alternating pairs of the segmenting fluid volumes in said first channel.

**27.** Apparatus as set forth in Claim 23 comprising:

additional electrical contacts located along the first channel between the third channel and the fluid reservoir; and
means for applying electrical potentials between respective pairs of the additional electrical contacts for transporting the segmenting fluid volume along said first channel toward said fluid reservoir.

**28.** Apparatus as set forth in Claim 23 wherein said first channel comprises a loop (64a, b, c) for holding a plurality of said reaction particles disposed between alternating pairs of the segmenting fluid volumes.


**Patentansprüche**

**1.** Verfahren zur Bildung und zum Transport einer Reihe von winzigen Volumensegmenten eines Materials in einem Mikrokanal, umfassend die Schritte:

a. des Bereitstellens eines ersten Kanals (10) mit einem Einlassende (12), das mit einer Quelle des Transportfluids verbunden ist, und einem mit einem Fluidspeicher verbundenen Austrittsende (14);
b. des Bereitstellens eines zweiten Kanals (16) mit einem Einlassende (18), das mit einer Quelle eines Segmentierungsfluids verbunden ist, und einem mit dem ersten Kanal verbundenen Austrittsende (20);
c. des Hineinziehens eines Volumens des Segmentierungsfluids (22) in den ersten Kanal;
d. des Transportierens des Volumens des Segmentierungsfluids im ersten Kanal hin zum Fluidspeicher; und dann
e. des Wiederholens der Schritte c. und d. zur Bildung einer Reihe einzelner Volumina des Segmentierungsfluids;

**dadurch gekennzeichnet, dass** der Schritt des Hineinziehens des Volumens des Segmentierungsfluids in den ersten Kanal folgende Schritte umfasst:

a. Bereitstellen eines ersten (e1), zweiten (e2) und dritten (e3) elektrischen Kontakts im ersten Kanal an einer Stelle zwischen den Austrittsenden des ersten Kanals und des zweiten Kanals;
b. Bereitstellen eines vierten (e5), fünften (e6) und sechsten (e7) elektrischen Kontakts im ersten Kanal an einer Stelle zwischen dem Einlassende des ersten Kanals und dem Austrittsende des zweiten Kanals; und
c. Anlegen eines ersten elektrischen Potentials (24a) an dem ersten und zweiten elektrischen Kontakt und eines zweiten Potentials (24b) an dem vierten und fünften elektrischen Kontakt, wobei das erste und das zweite elektrische Potential eine Höhe und Polarität aufweist, die zum Hervorrufen einer Strömung des Transportfluids im ersten Kanal wirksam ist, um das Segmentierungsfluid in den ersten Kanal zu ziehen.

**2.** Verfahren nach Anspruch 1, umfassend die Schritte:

a. des Senkens der Höhe des zweiten elektrischen Potentials am vierten und fünften elektrischen Kontakt; und
b. des Aufrechterhaltens der Höhe und der Polarität des ersten elektrischen Potentials am ersten und zweiten elektrischen Kontakt, bis das gewünschte Volumen des Segmentierungsfluids in den ersten Kanal hineingezogen worden ist.

**3.** Verfahren nach Anspruch 2, worin der Schritt des Transportierens des Volumens des Segmentierungsfluids im ersten Kanal folgende Schritte umfasst:

a. Anlegen eines dritten elektrischen Potentials (24c) am fünften und sechsten elektrischen Kontakt, während das erste elektrische Potential an dem ersten und zweiten elektrischen aufrechterhalten wird, bis das Volumen des Segmentierungsfluids den ersten elektrischen Kontakt erreicht; und dann
b. Anlegen eines vierten elektrischen Potentials an dem zweiten und dritten elektrischen Kontakt, wodurch das Volumen des Segmentierungsfluids zum zweiten elektrischen Kontakt hin transportiert wird.

**4.** Verfahren nach Anspruch 1, umfassend den Schritt des Einspritzens eines Volumens eines Reagens (34, 434) in den ersten Kanal zwischen einem aufeinander-folgenden Paar an Volumina des Segmentierungsfluids.

**5.** Verfahren nach Anspruch 4, worin der Schritt des Einspritzens des Reagens folgende Schritte umfasst:

a. Bereitstellen eines dritten Kanals (28, 428) mit einem mit einer Quelle eines Reagens verbundenen Einlassende (30, 430) und einem mit dem ersten Kanal verbundenen Austrittsende (32);

b. Bereitstellen eines vierten Kanals (38) mit einem mit dem ersten Kanal verbundenen Einlassende; und

c. Anlegen eines elektrischen Potentials zwischen dem dritten Kanal und dem vierten Kanal, um herbeizuführen, dass das Volumen des Reagens in den ersten Kanal fließt und das Transportfluid in den vierten Kanal fließt.

**6.** Verfahren nach Anspruch 4, umfassend den Schritt des Verdünnens der Konzentration des Reagens, bevor dieses in den ersten Kanal eingespritzt wird.

**7.** Verfahren nach Anspruch 4, umfassend den Schritt des Wiederholens der Einspritzung des Reagens in den ersten Kanal, sodass eine Vielzahl an Volumina (36a, 36b) des Reagens zwischen nicht aneinander liegenden, aber aufeinander folgenden Paaren an Volumina (26b, 26c; 26d, 26e) des Segmentierungsfluids injiziert werden.

**8.** Verfahren nach Anspruch 7, umfassend den Schritt des Transportierens der Vielzahl an eingespritzten Reagensvolumina den ersten Kanal entlang hin zum Fluidspeicher.

**9.** Verfahren nach Anspruch 8, umfassend den Schritt des sequentiellen Einlagerns der Vielzahl an eingespritzten Reagensvolumina, sodass ein ausgewähltes Reagensvolumen zur Analyse erhalten werden kann.

**10.** Verfahren nach Anspruch 9, umfassend den Schritt des Erhaltens des ausgewählten Reagensvolumens aus dem Lager.

**11.** Verfahren nach Anspruch 1, umfassend den Schritt des Einführens eines Reaktionsteilchens (44) in den ersten Kanal zwischen ein aufeinander folgendes Paar an Volumina des Segmentierungsfluids.

**12.** Verfahren nach Anspruch 11, umfassend den Schritt des Wiederholens des Einführens des Reaktionsteilchens in den ersten Kanal, sodass eine Vielzahl an Reaktionsteilchen zwischen nicht aneinander liegenden, aber aufeinander folgenden Paaren an Volumina (26b, 26c; 26d, 26e) des Segmentierungsfluids eingeführt werden.

**13.** Verfahren nach Anspruch 11, umfassend den Schritt des Transportierens der Vielzahl an Reaktionsteilchen den ersten Kanal entlang hin zum Fluidspeicher.

**14.** Verfahren nach Anspruch 13, umfassend den Schritt des sequentiellen Einlagerns der Vielzahl an eingeführten Reaktionsteilchen, sodass ein ausgewähltes Reaktionsteilchen zur Analyse erhalten werden kann.

**15.** Verfahren nach Anspruch 14, umfassend den Schritt des Erhaltens des ausgewählten Reaktionsteilchens aus dem Lager.

**16.** Vorrichtung zur Bildung und zum Transport einer Reihe von winzigen Volumensegmenten eines Materials, umfassend:

ein Substrat mit einem in diesem ausgebildeten ersten (10) und zweiten (16) Mikrokanal, wobei der erste Mikrokanal ein Einlassende (12), das mit einer Quelle eines Transportfluids verbunden ist, und ein mit einem Fluidspeicher verbundenes Austrittsende (14) aufweist, und der zweite Mikrokanal (16) ein Einlassende (18), das mit einer Quelle des Segmentierungsfluids verbunden ist, und ein mit dem ersten Mikrokanal verbundenes Austrittsende (20) aufweist;

**dadurch gekennzeichnet, dass** die Vorrichtung zudem umfasst:

einen ersten (e1), zweiten (e2) und dritten (e3) elektrischen Kontakt, die im ersten Mikrokanal an einer Stelle zwischen dem Austrittsende des ersten Mikrokanals und dem zweiten Mikrokanal angeordnet sind;

einen vierten (e5), fünften (e6) und sechsten (e7) elektrischen Kontakt, die im ersten Mikrokanal an einer Stelle zwischen dem Einlassende des ersten Mikrokanals und dem zweiten Mikrokanal angeordnet sind;

Mittel zum sequentiellen Anlegen von elektrischen Potentialen an den nebeneinander liegenden Paaren an elektrischen Kontakten, um (i) ein Volumen des Segmentierungsfluids in den ersten Mikrokanal zu ziehen, (ii) das Hineinziehen des Segmentierungsfluidvolumens in den ersten Mikrokanal zu beenden und dann (iii) die Volumina des Segmentierungsfluids im ersten Mikrokanal hin zum Fluidspeicher zu transportieren.

**17.** Vorrichtung nach Anspruch 16, umfassend:

einen dritten Kanal (28, 428) mit einem mit einer Quelle eines Reagens verbundenen Einlassende (30, 430) und einem mit dem ersten Kanal verbundenen Austrittsende (32);
einen vierten Kanal (38) mit einem mit dem ersten Kanal verbundenen Einlassende; und
Mittel zum Einspritzen eines Reagensvolumens zwischen ein Paar an aufeinander folgenden Volumina des Segmentierungsfluids im ersten Kanal, sodass das zwischen dem Paar an aufeinander folgenden Volumina des Segmentierungsfluids liegende Transportfluid veranlasst wird, in den vierten Kanal zu fließen.

**18.** Vorrichtung nach Anspruch 17, umfassend Mittel zum Anlegen eines elektrischen Potentials zwischen dem dritten Kanal und dem vierten Kanal zur Einspritzung des Reagensvolumens.

**19.** Vorrichtung nach Anspruch 17, umfassend Mittel zur Verdünnung des Reagens, wenn dieses in den ersten Kanal eingespritzt wird.

**20.** Vorrichtung nach Anspruch 18, umfassend Mittel zum Variieren der Verdünnung des Reagens, um eine Reihe von Volumina an verdünnten Reagenzien mit unterschiedlichen Konzentrationen bereitzustellen, und Mittel zur Einspritzung eines jeden der Volumina in alternierende Paare an Segmentierungsfluidvolumina im ersten Kanal.

**21.** Vorrichtung nach Anspruch 17, umfassend:

zusätzliche, entlang dem ersten Kanal und zwischen dem dritten Kanal und dem Fluidspeicher angeordnete elektrische Kontakte; und
Mittel zum Anlegen elektrischer Potentiale zwischen den jeweiligen Paaren an zusätzlichen elektrischen Kontakten zum Transport des Reaktionsvolumens den ersten Kanal entlang hin zum Fluidspeicher.

**22.** Vorrichtung nach Anspruch 17, worin der erste Kanal eine Schleife (64a, b, c) zum Halten einer Vielzahl der verdünnten Reagensvolumina aufweist, die sich zwischen alternierenden Paaren an Segmentierungsfluidvolumina befinden.

**23.** Vorrichtung nach Anspruch 16, umfassend:

einen dritten Kanal (50) mit einem mit einer Quelle der Reaktionsteilchen (44), die in einem Fluidmedium suspendiert sind, verbundenen Einlassende (50a) und einem mit dem ersten Kanal verbundenen Austrittsende;
einen vierten Kanal (38) mit einem mit dem ersten Kanal verbundenen Einlassende; und
Mittel zum Einspritzen eines im Fluidmedium suspendierten Reaktionsteilchens zwischen ein Paar an aufeinander folgenden Volumina des Segmentierungsfluids im ersten Kanal, sodass das zwischen dem Paar an aufeinander folgenden Volumina des Segmentierungsfluids angeordneten Transportfluid veranlasst wird, in den vierten Kanal zu fließen.

**24.** Vorrichtung nach Anspruch 23, umfassend Mittel zum Anlegen eines elektrischen Potentials zwischen dem dritten Kanal und dem vierten Kanal, um zu veranlassen, dass ein Volumen des das Reaktionteilchen beinhaltenden Fluidmediums in den ersten Kanal fließt und das Transportfluid in den vierten Kanal fließt.

**25.** Vorrichtung nach Anspruch 23, umfassend Mittel zum Sortieren der Reaktionsteilchen auf Grundlage eines Merkmals oder einer Eigenschaft des Reaktionsteilchens und Mittel zum Einspritzen einzelner Reaktionsteilchen zwischen ein Paar an aufeinander folgenden Volumina des Segmentierungsfluids im ersten Kanal.

**26.** Vorrichtung nach Anspruch 25, umfassend Mittel zum Steuern der Einspritzung eines jeden Reaktionsteilchens, sodass die Reaktionsteilchen zwischen alternierende Paare an Segmentierungsfluidvolumina im ersten Kanal eingeführt werden.

**27.** Vorrichtung nach Anspruch 25, umfassend:

zusätzliche, entlang dem ersten Kanal und zwischen dem dritten Kanal und dem Fluidspeicher angeordnete elektrische Kontakte; und
Mittel zum Anlegen elektrischer Potentiale zwischen den jeweiligen Paaren an zusätzlichen elektrischen Kontakten zum Transport des Segmentierungsfluidvolumens den ersten Kanal entlang hin zum Fluidspeicher.

**28.** Vorrichtung nach Anspruch 25, worin der erste Kanal eine Schleife (64a, b, c) zum Halten einer Vielzahl an Reaktionsteilchen aufweist, die sich zwischen alternierenden Paaren an Segmentierungsfluidvolumen befinden.

**Revendications**

**1.** Procédé de formation et de transport d'une série de segments infimes de volume d'un matériau dans un microcanal comprenant les étapes consistant à:

a. fournir un premier canal (10) ayant une extrémité d'entrée (12) connectée à une source de fluide de transport et une extrémité de sortie (14) connectée à un réservoir de fluide;
b. fournir un deuxième canal (16) ayant une extrémité d'entrée (18) connectée à une source de fluide de segmentation et une extrémité de sortie (20) interconnectée avec ledit premier canal;
c. tirer un volume de fluide de segmentation (22) dans ledit premier canal;
d. transporter le volume de fluide de segmentation dans ledit premier canal vers ledit réservoir de fluide; et puis
e. répéter les étapes c. et d. pour former une série de volumes discrets du fluide de segmentation;

**caractérisé en ce que** l'étape consistant à tirer le volume de fluide de segmentation dans le premier canal comprend les étapes consistant à:

a. fournir un premier (e1), deuxième (e2) et troisième (e3) contacts électriques dans ledit premier canal à un emplacement entre les extrémités de sortie dudit premier canal et dudit deuxième canal;
b. fournir un quatrième (e5), cinquième (e6) et sixième (e7) contacts électriques dans ledit premier canal à un emplacement entre l'extrémité d'entrée dudit premier canal et l'extrémité de sortie dudit deuxième canal; et
c. appliquer un premier potentiel électrique (24a) sur lesdits premier et deuxième contacts électriques et un deuxième potentiel électrique (24b) sur lesdits quatrième et cinquième contacts électriques, lesdits premier et deuxième potentiels électriques ayant des magnitudes et des polarités qui sont efficaces pour induire l'écoulement dudit fluide de transport dans ledit premier canal afin de tirer le fluide de segmentation dans ledit premier canal.

**2.** Procédé selon la revendication 1, comprenant les étapes consistant à:

a. réduire la magnitude du deuxième potentiel électrique sur lesdits quatrième et cinquième contacts électriques; et
b. maintenir la magnitude et la polarité du premier potentiel électrique sur lesdits premier et deuxième contacts électriques jusqu'à ce que le volume souhaité de fluide de segmentation ait été tiré dans le premier canal.

**3.** Procédé selon la revendication 2, dans lequel l'étape consistant à transporter le volume de fluide de segmentation dans ledit premier canal comprend les étapes consistant à:

a. appliquer un troisième potentiel électrique (24c) sur lesdits cinquième et sixième contacts électriques tout en maintenant le premier potentiel électrique sur lesdits premier et deuxième contacts électriques jusqu'à ce que le volume de fluide de segmentation atteigne ledit premier contact électrique; et puis
b. appliquer un quatrième potentiel électrique sur les deuxième et troisième contacts électriques, moyennant quoi le volume de fluide de segmentation est transporté vers le deuxième contact électrique.

**4.** Procédé selon la revendication 1, comprenant l'étape consistant à injecter un volume de réactif (34, 434) dans ledit premier canal entre une paire séquentielle des volumes du fluide de segmentation.

**5.** Procédé selon la revendication 4, dans lequel l'étape consistant à injecter le réactif comprend les étapes consistant à:

a. fournir un troisième canal (28, 428) ayant une extrémité d'entrée (30, 430) connectée à une source de réactif et une extrémité de sortie (32) interconnectée avec le premier canal;
b. fournir un quatrième canal (38) ayant une extrémité d'entrée interconnectée avec le premier canal; et
c. appliquer un potentiel électrique entre le troisième canal et le quatrième canal pour pousser le volume du réactif à d'écouler dans ledit premier canal et le fluide de transport à s'écouler dans ledit quatrième canal.

6.  Procédé selon la revendication 4, comprenant l'étape consistant à diluer la concentration du réactif avant qu'il ne soit injecté dans le premier canal.

7.  Procédé selon la revendication 4, comprenant l'étape consistant à répéter l'injection du réactif dans le premier canal de telle sorte qu'une pluralité de volumes (36a, 36b) de réactif soient injectés entre des paires séquentielles non-adjacentes de volumes (26b, 26c; 26d, 26e) du fluide de segmentation.

8.  Procédé selon la revendication 7, comprenant l'étape consistant à transporter la pluralité de volumes injectés de réactif le long dudit premier canal vers ledit réservoir de fluide.

9.  Procédé selon la revendication 8, comprenant l'étape consistant à séquentiellement stocker la pluralité de volumes injectés de réactif afin qu'un volume choisi desdits volumes de réactif puisse être récupéré pour analyse.

10. Procédé selon la revendication 9, comprenant l'étape consistant à récupérer le volume de réactif choisi du stockage.

11. Procédé selon la revendication 1, comprenant l'étape consistant à insérer une particule de réaction (44) dans ledit premier canal entre une paire séquentielle des volumes du fluide de segmentation.

12. Procédé selon la revendication 11, comprenant l'étape consistant à répéter l'insertion de la particule de réaction dans le premier canal de telle sorte qu'une pluralité de particules de réaction soient insérées entre des paires séquentielles non-adjacentes (26b, 26c; 26d, 26a) de volumes du fluide de segmentation.

13. Procédé selon la revendication 11, comprenant l'étape consistant à transporter la pluralité de particules de réaction le long dudit premier canal vers ledit réservoir de fluide.

14. Procédé selon la revendication 13 comprenant l'étape consistant à séquentiellement stocker la pluralité de particules de réaction insérées afin qu'une particule choisie parmi lesdites particules de réaction puisse être récupérée pour analyse.

15. Procédé selon la revendication 14, comprenant l'étape consistant à récupérer la particule de réaction choisie du stockage.

16. Appareil pour former et transporter une série de segments infimes de volume d'un matériau comprenant:

    un substrat ayant des premier (10) et deuxième (16) microcanaux formés à l'intérieur de celui-ci, ledit premier microcanal ayant une extrémité d'entrée (12) connectée à une source de fluide de transport et une extrémité de sortie (14) connectée à un réservoir de fluide, ledit deuxième microcanal ayant une extrémité d'entrée (18) connectée à une source de fluide de segmentation et une extrémité de sortie (20) interconnectée avec ledit premier microcanal; **caractérisé en ce que** l'appareil comprend en outre:

    un premier (e1), deuxième (e2) et troisième (e3) contacts électriques disposés dans ledit premier microcanal à un emplacement entre l'extrémité de sortie dudit premier microcanal et ledit deuxième microcanal; un quatrième (e5), cinquième (e6) et sixième (e7) contacts électriques disposés dans ledit premier microcanal à un emplacement entre l'extrémité d'entrée dudit premier canal et ledit deuxième microcanal; et des moyens pour séquentiellement appliquer des potentiels électriques sur des paires adjacentes desdits contacts électriques pour (i) tirer un volume de fluide de segmentation dans ledit premier microcanal, (ii) arrêter le tirage du volume de fl uide de segmentation dans le premier microcanal, et puis (iii) transporter les volumes du fluide de segmentation dans ledit premier microcanal vers ledit réservoir de fluide.

17. Appareil selon la revendication 16, comprenant:

    un troisième canal (28, 428) ayant une extrémité d'entrée (30, 430) connectée à une source de réactif et une extrémité de sortie (32) interconnectée avec le premier canal;
    un quatrième canal (38) ayant une extrémité d'entrée interconnectée avec le premier canal; et
    des moyens pour injecter un volume du réactif entre une paire de volumes séquentiels du fluide de segmentation dans ledit premier canal de telle sorte que le fluide de transport disposé entre ladite paire de volumes séquentiels du fluide de segmentation est poussé à s'écouler dans ledit quatrième canal.

18. Appareil selon la revendication 17, comprenant des moyens pour appliquer un potentiel électrique entre le troisième canal et le quatrième canal pour injecter le volume du réactif.

19. Appareil selon la revendication 17, comprenant des moyens pour diluer le réactif lorsqu'il est injecté dans le premier canal.

20. Appareil selon la revendication 18, comprenant des moyens pour varier la dilution du réactif pour fournir une série de volumes de réactif dilué ayant différentes concentrations et des moyens pour injecter chacun des volumes dans des paires alternatives des volumes de fluide de segmentation dans ledit premier canal.

21. Appareil selon la revendication 17, comprenant:

   des contacts électriques supplémentaires situés le long du premier canal entre le troisième canal et le réservoir de fluide; et
   des moyens pour appliquer des potentiels électriques entre des paires respectives des contacts électriques supplémentaires pour transporter le volume de réaction le long dudit premier canal vers ledit réservoir de fluide.

22. Appareil selon la revendication 17, dans lequel ledit premier canal comprend une boucle (64a, b, c) pour tenir une pluralité desdits volumes de réactif dilué disposés entre des paires alternées des volumes de fluide de segmentation.

23. Appareil selon la revendication 16, comprenant:

   un troisième canal (50) ayant une extrémité d'entrée (50a) connectée à une source de particules de réaction (44) suspendues dans un milieu fluide et une extrémité de sortie interconnectée avec le premier canal;
   un quatrième canal (38) ayant une extrémité d'entrée interconnectée avec le premier canal; et
   des moyens pour injecter une particule de réaction suspendue dans le milieu fluide entre une paire de volumes séquentiels du fluide de segmentation dans ledit premier canal de telle façon que le fluide de transport disposé entre ladite paire de volumes séquentiels du fluide de segmentation soit poussé à s'écouler dans ledit quatrième canal.

24. Appareil selon la revendication 23, comprenant des moyens pour appliquer un potentiel électrique entre le troisième canal et le quatrième canal pour pousser un volume du milieu fluide contenant la particule de réaction à s'écouler dans ledit premier canal et le fluide de transport à s'écouler dans ledit quatrième canal.

25. Appareil selon la revendication 23, comprenant des moyens pour trier les particules de réaction selon une qualité ou caractéristique des particules de réaction et des moyens pour injecter des particules de réaction individuelles entre une paire de volumes séquentiels du fluide de segmentation dans ledit premier canal.

26. Appareil selon la revendication 25, comprenant des moyens pour contrôler l'injection de chacune des particules de réaction de telle façon que les particules de réaction soient insérées entre des paires alternées des volumes de fluide de segmentation dans ledit premier canal.

27. Appareil selon la revendication 23, comprenant:

   des contacts électriques supplémentaires situés le long du premier canal entre le troisième canal et le réservoir de fluide; et
   des moyens pour appliquer des potentiels électriques entre des paires respectives des contacts électriques supplémentaires pour transporter le volume de fluide de segmentation le long dudit premier canal vers ledit réservoir de fluide.

28. Appareil selon la revendication 23, dans lequel ledit premier canal comprend une boucle (64a, b, c) pour tenir une pluralité desdites particules de réaction disposées entre des paires alternées des volumes de fluide de segmentation.

FIG. IA          FIG. IB          FIG. IC

EP 1 202 802 B1

FIG. 2

FIG. 3

**FIG. 4**

**FIG. 5**

FIG. 6

FIG. 7

FIG. 8